(19) Europäisches Patentamt
European Patent Office
Office européen des brevets

(11) EP 3 739 350 A1

(12) DEMANDE DE BREVET EUROPEEN

(43) Date de publication:
18.11.2020 Bulletin 2020/47

(51) Int Cl.:
G01R 31/34 (2020.01)  H02P 21/14 (2016.01)
H02P 21/16 (2016.01)

(21) Numéro de dépôt: 20174631.0

(22) Date de dépôt: 14.05.2020

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 15.05.2019 FR 1905074

(71) Demandeur: ALSTOM Transport Technologies
93400 Saint-Ouen (FR)

(72) Inventeur: LEFEBVRE, Gaetan
31800 SAINT-GAUDENS (FR)

(74) Mandataire: Lavoix
2, place d'Estienne d'Orves
75441 Paris Cedex 09 (FR)

(54) **DISPOSITIF ÉLECTRONIQUE ET PROCÉDÉ D'ESTIMATION D'UNE RÉSISTANCE ROTORIQUE D'UNE MACHINE ÉLECTRIQUE**

(57) L'invention concerne un dispositif électronique (50) d'estimation d'une résistance rotorique d'une machine électrique (26) apte à être connectée à un convertisseur d'énergie électrique (30) piloté par un dispositif de pilotage (40).

Le dispositif d'estimation (50) comprend :
- un module d'injection (52) configuré pour déterminer une consigne de flux ($\varphi^{\#}$) à injecter en entrée du dispositif de pilotage (40) ;
- un module (54) d'acquisition d'une mesure d'un courant représentatif d'un courant d'au moins une phase de la machine à un instant donné ; et
- un module (56) de calcul d'une valeur de la résistance rotorique de la machine à un instant suivant, postérieur à l'instant donné, en fonction d'une variation de la consigne de flux, d'une valeur précédente de la résistance rotorique pour ledit instant donné, et dudit courant mesuré ; des valeurs initiales de la résistance rotorique et du courant étant prédéfinies.

FIG.2

**EP 3 739 350 A1**

**Description**

La présente invention concerne un dispositif électronique d'estimation d'une résistance rotorique d'une machine électrique, ladite machine électrique étant destinée à être embarquée dans un véhicule pour tracter ledit véhicule, tel qu'un véhicule électrique de transport, par exemple un véhicule ferroviaire.

L'invention concerne également un procédé d'estimation d'une résistance rotorique d'une machine électrique. Particulièrement, le procédé d'estimation de l'invention est mis en œuvre en l'absence d'un capteur de vitesse de rotation de la machine électrique.

L'invention concerne également une chaîne de traction pour un véhicule, tel qu'un véhicule électrique de transport, par exemple un véhicule ferroviaire, la chaîne de traction comprenant un tel dispositif électronique d'estimation d'une résistance rotorique d'une machine électrique.

L'invention concerne également un véhicule, tel qu'un véhicule électrique de transport, par exemple un véhicule ferroviaire, comprenant une telle chaîne de traction. La chaine de traction est configurée pour provoquer un déplacement du véhicule.

L'invention est applicable à une machine électrique, en particulier une machine asynchrone à courant alternatif. L'invention est aussi applicable à une machine à reluctance variable.

L'invention s'applique au domaine des transports, en particulier du transport ferroviaire, notamment aux véhicules de traction électrique.

La connaissance de la valeur de la résistance rotorique d'une machine électrique est nécessaire pour réaliser une régulation précise du couple d'une telle machine, ainsi que pour réaliser une protection thermique de celle-ci. La résistance rotorique est toutefois amenée à varier au cours du fonctionnement de la machine dans une grande amplitude, par exemple, jusqu'à un facteur de 2 à 3. Il en résulte qu'il est nécessaire d'avoir une estimation précise de la valeur de cette résistance rotorique au cours du fonctionnement de la machine.

Classiquement, une telle estimation est effectuée à l'aide d'une mesure de la vitesse de rotation, également appelée vitesse rotorique, de la machine électrique, au moyen d'un capteur de vitesse rotorique. Néanmoins, la présence d'un capteur de vitesse augmente les coûts, notamment de maintenance, d'une telle machine électrique.

On connait également de l'article intitulé «Speed Sensorless Field-Oriented Control of Induction Motor with Rotor Resistance Adaption» (Hisao Kubota et Kouki Matsuse, IEEE Transactions on Industry Applications, Vol.30, No. 5, September/October 1994) un dispositif d'estimation de la valeur de la vitesse et de la résistance rotorique d'une machine asynchrone en l'absence de capteur de vitesse. Un tel dispositif met en œuvre une superposition d'une composante à courant alternatif sur une commande d'un courant de champ afin d'estimer simultanément la vitesse du moteur et la résistance rotorique. Ensuite, une commande d'un courant de couple est calculée à partir d'une commande du couple et d'un flux estimé du rotor. Autrement dit, l'estimation de la résistance rotorique est réalisée en imposant une variation de flux et en observant ensuite d'autres grandeurs au niveau de la machine, notamment le flux de la machine.

Toutefois, la résistance rotorique ainsi calculée n'est pas très fiable. En effet, le flux à observer de la machine peut être considéré égal à un terme de courant filtré par un filtre d'ordre 1 et de gain $L_m$, en notant ici $L_m$ une inductance magnétisante de la machine électrique. Autrement dit, en régime permanent le calcul de l'expression $\varphi - L_m \cdot i$, où $\varphi$ est le flux à observer et $i$ est le courant correspondant, donne une valeur sensiblement nulle. Par conséquent, l'obtention d'une valeur de la résistance rotorique nécessite une variation du flux qui est réalisée dans l'article de Hisao Kubota et Kouki Matsuse par une injection d'un motif sinusoïdal. Or, lorsque ce motif sinusoïdal est injecté, la valeur donnée par $\varphi - L_m \cdot i$ reste faible par rapport aux grandeurs $\varphi$ ou $L_m \cdot i$ et est alors particulièrement sensible à une erreur sur la valeur de l'inductance magnétisante $L_m$.

La présente invention a donc pour but de proposer un dispositif électronique d'estimation d'une résistance rotorique d'une machine électrique, n'utilisant pas de mesure de la vitesse de rotation de la machine, tout en permettant d'obtenir une valeur plus fiable de la résistance rotorique.

A cet effet, l'invention a pour objet un dispositif d'estimation d'une résistance rotorique d'une machine électrique, ladite machine électrique étant destinée à être embarquée dans un véhicule pour tracter ledit véhicule, tel qu'un véhicule électrique de transport, par exemple un véhicule ferroviaire, et apte à être connectée à un convertisseur d'énergie électrique, ledit convertisseur d'énergie électrique étant configuré pour alimenter électriquement la machine à partir d'une source électrique et étant apte à être piloté par un dispositif de pilotage, le dispositif d'estimation étant apte à être relié au dispositif de pilotage du convertisseur d'énergie électrique et comprenant :

- un module d'injection configuré pour déterminer une consigne de flux à injecter en entrée du dispositif de pilotage ;
- un module d'acquisition configuré pour acquérir une mesure d'un courant représentatif d'un courant d'au moins une phase de la machine électrique à un instant temporel donné ; et
- un module de calcul configuré pour calculer une valeur de la résistance rotorique de la machine électrique à un instant temporel suivant, postérieur à l'instant temporel donné, en fonction d'une variation de la consigne de flux, d'une valeur précédente de la résistance rotorique pour ledit instant temporel donné, et du courant mesuré représentatif du courant de phase audit instant temporel donné ; des valeurs initiales de la résistance rotorique et du courant étant prédéfinies.

Le dispositif électronique d'estimation selon l'invention permet de réaliser une telle estimation en déterminant une consigne de flux à injecter, qui apporte une variation de l'amplitude du flux, et en exploitant le lien de proportionnalité entre la variation de la consigne de flux et la valeur de la résistance rotorique.

Le dispositif électronique d'estimation selon l'invention permet de réaliser une telle estimation en déterminant une consigne de flux à injecter en entrée du dispositif de pilotage et en imposant ainsi une composante variable à la composante continue du flux, l'estimation de la résistance rotorique est alors par exemple obtenue à partir de l'équation d'évolution du flux de la machine et d'un courant de phase mesuré. Cela simplifie considérablement l'ensemble des grandeurs à observer.

La présente invention permet alors de réaliser une estimation d'une résistance rotorique d'une manière plus simple et plus robuste, sans recourir à une mesure de la fréquence de glissement de la machine électrique, et avec une résistance rotorique obtenue qui est moins sensible aux erreurs de paramètres de la machine électrique.

Suivant d'autres aspects avantageux de l'invention, le dispositif électronique d'estimation comporte l'une ou plusieurs des caractéristiques suivantes, prises isolément ou suivant toutes les combinaisons techniquement possibles :

- ladite machine électrique a une inductance rotorique et une inductance magnétisante, et le module de calcul est configuré pour calculer la valeur de la résistance rotorique en fonction en outre de l'inductance rotorique et de l'inductance magnétisante ;
- le module de calcul est configuré pour calculer la valeur de la résistance rotorique selon l'équation suivante :

[Math 1]

$$Rr_{n+1} = \dot{\varphi}^{\#} \cdot \frac{1}{Id_n} \cdot G$$

où $\dot{\varphi}^{\#}$ est la variation de la consigne de flux ;

$Id_n$ est le courant représentatif du courant de phase selon un axe direct, mesuré à l'instant temporel donné ;
G représentant un facteur dépendant de la valeur précédente de résistance rotorique pour ledit instant temporel donné, de l'inductance rotorique et de l'inductance magnétisante ;

- le module de calcul est configuré pour calculer la valeur de la résistance rotorique selon l'équation suivante :

[Math 2]

$$Rr_{n+1} = \dot{\varphi}^{\#} \cdot \frac{L_r}{L_m} \cdot \left( \frac{1 + \frac{L_r}{Rr_n} p}{\frac{L_r}{Rr_n} p} \right) \cdot \frac{1}{Id_n}$$

où $\dot{\varphi}^{\#}$ est la variation de la consigne de flux ;

$L_r$ est l'inductance rotorique de la machine électrique ;
$L_m$ est l'inductance magnétisante de la machine électrique ;
$Rr_n$ est une valeur précédente de résistance rotorique pour ledit instant temporel donné ;
$\frac{L_r}{Rr_n}$ p correspondant au Laplacien de $\frac{L_r}{Rr_n}$,
$Id_n$ est le courant représentatif du courant de phase selon l'axe direct, mesuré à l'instant temporel donné ;

- le module d'injection est configuré pour déterminer une consigne de flux en forme d'un signal triangulaire ;
- le flux de la machine électrique a une composante continue, la consigne de flux a une composante variable, et l'amplitude de ladite composante variable est supérieure ou égale à 15% de celle de ladite composante continue ;
- le module d'injection est configuré pour déterminer une consigne de flux ayant une composante variable avec une fréquence comprise entre 1 Hz et 10 Hz ;
- le dispositif d'estimation est configuré pour estimer la résistance rotorique de la machine électrique en l'absence d'un capteur de mesure d'une vitesse rotorique de la machine électrique ; et

- le dispositif d'estimation est configuré pour estimer la résistance rotorique de la machine électrique en l'absence d'un capteur de mesure d'un flux de la machine électrique.

L'invention a également pour objet un procédé d'estimation d'une résistance rotorique d'une machine électrique, ladite machine électrique étant destinée à être embarquée dans un véhicule pour tracter ledit véhicule, tel qu'un véhicule électrique de transport, par exemple un véhicule ferroviaire, et apte à être connectée à un convertisseur d'énergie électrique, ledit convertisseur d'énergie électrique étant configuré pour alimenter électriquement la machine à partir d'une source électrique et étant apte à être piloté par un dispositif de pilotage,
le procédé d'estimation étant mis en œuvre par un dispositif électronique d'estimation, et comprenant :

- détermination d'une consigne de flux à injecter en entrée du dispositif de pilotage;
- mesure d'un courant représentatif d'un courant d'une phase de la machine électrique à un instant temporel donné ; et
- calcul d'une valeur de la résistance rotorique de la machine électrique à un instant temporel suivant, postérieur à l'instant temporel donné en fonction d'une variation de la consigne de flux, d'une valeur précédente de la résistance rotorique pour ledit instant temporel donné, et du courant mesuré représentatif du courant de phase audit instant temporel donné ; des valeurs initiales de la résistance rotorique et du courant étant prédéfinies.

L'invention a également pour objet une chaîne de traction pour un véhicule, tel qu'un véhicule électrique de transport, par exemple un véhicule ferroviaire, la chaine de traction comprenant :

- une machine électrique adaptée pour tracter ledit véhicule,
- un convertisseur d'énergie électrique connecté à la machine électrique et configuré pour alimenter électriquement la machine à partir d'une source électrique,
- un dispositif de pilotage configuré pour piloter le convertisseur d'énergie électrique,
- un dispositif électronique d'estimation configuré pour estimer une résistance rotorique d'une machine électrique, le dispositif électronique d'estimation étant tel que défini ci-dessus.

L'invention a également pour objet un véhicule, tel qu'un véhicule électrique de transport, par exemple un véhicule ferroviaire, comprenant une chaîne de traction telle que définie ci-dessus.
Ces caractéristiques et avantages de l'invention apparaîtront plus clairement à la lecture de la description qui va suivre, donnée uniquement à titre d'exemple non limitatif, et faite en référence aux dessins annexés, sur lesquels :

[Fig 1] la figure 1 est une représentation schématique d'un véhicule électrique de transport, tel qu'un véhicule ferroviaire, comprenant une chaîne de traction selon l'invention ;
[Fig 2] la figure 2 est une représentation schématique de la chaine de traction de la figure 1, comprenant notamment une machine électrique et un dispositif électronique d'estimation d'une résistance rotorique de ladite machine ; et
[Fig 3] la figure 3 est un organigramme d'un procédé, selon l'invention, d'estimation d'une résistance rotorique de la machine.

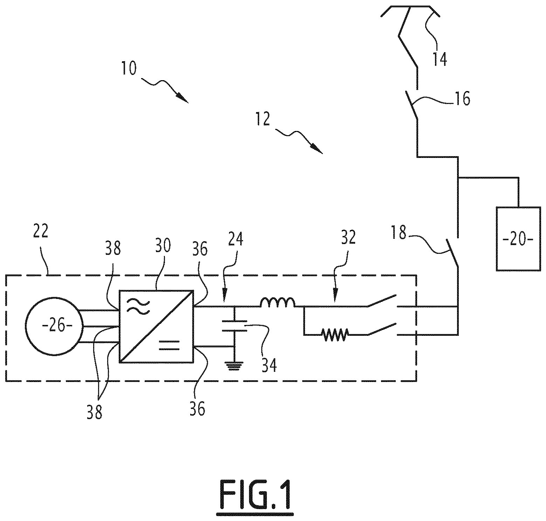

Sur la figure 1, un véhicule électrique de transport 10, tel qu'un véhicule ferroviaire, comprend une chaîne de traction 12, la chaîne de traction 12 comportant un pantographe 14 apte à être connecté à une caténaire, non représentée.
La chaîne de traction 12 comprend un commutateur électrique 16 connecté au pantographe 14 et un disjoncteur électrique 18 connecté au commutateur électrique 16. La chaîne de traction 12 comprend, en complément facultatif, un équipement auxiliaire 20 connecté entre le commutateur électrique 16 et le disjoncteur électrique 18, en dérivation par rapport au disjoncteur électrique 18.
Le commutateur électrique 16, le disjoncteur électrique 18 et l'équipement auxiliaire 20 sont connus en soi, et ne sont pas décrits plus en détail. L'équipement auxiliaire 20 est par exemple un convertisseur statique.
L'ensemble de traction 22 est connecté au disjoncteur électrique 18 via un bus continu 24. L'ensemble de traction 22 comporte une machine électrique 26, un convertisseur d'énergie électrique 30 relié à la machine électrique 26. Dans l'exemple de la figure 1, le convertisseur d'énergie électrique 30 est destiné à délivrer une tension alternative à la machine 26 à partir d'une tension continue issue du bus continu 24.
En complément, l'ensemble de traction 22 comporte un dispositif de filtrage 32, comportant notamment un condensateur de filtrage 34.
En complément facultatif, l'ensemble de traction 22 comporte un appareil de stockage d'énergie électrique, non représenté, l'appareil de stockage d'énergie électrique étant également appelé coffre d'autonomie, et servant, d'une part, de source d'alimentation auxiliaire, et d'autre part, à récupérer de l'énergie électrique lors d'un freinage du véhicule électrique de transport 10. L'appareil de stockage d'énergie électrique est par exemple connecté en dérivation, entre le disjoncteur électrique 18 et le condensateur de filtrage 34.

La machine électrique 26 est par exemple un moteur alternatif, tel qu'un moteur triphasé.

La machine électrique 26 a des paramètres caractéristiques, à savoir une inductance rotorique $L_r$ et une inductance magnétisante $L_m$. L'inductance rotorique $L_r$ et l'inductance magnétisante $L_m$ sont de préférence supposées chacune de valeur constante, au cours de la période temporelle considérée pour l'estimation d'une résistance rotorique $Rr$ de ladite machine 26.

Le convertisseur d'énergie électrique 30 est connecté à la machine électrique 26, et est configuré pour alimenter électriquement la machine électrique 26 à partir d'une source électrique et comporte par exemple un onduleur. Dans l'exemple de la figure 1, la source électrique est le réseau électrique associé à la caténaire à laquelle le pantographe 14 est apte à être connecté.

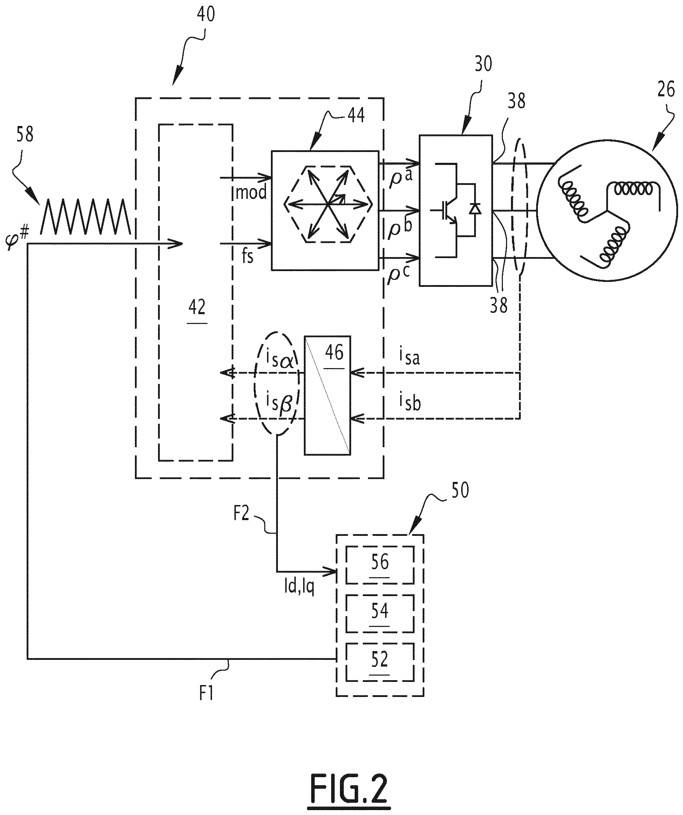

Sur la figure 2, la chaîne de traction 12 comprend un dispositif de pilotage 40 connecté au convertisseur d'énergie électrique 30. Le dispositif de pilotage 40 est configuré pour piloter le convertisseur d'énergie électrique 30, et comprend une unité de commande 42, une unité de modulation 44, et une unité de mesure 46, l'unité de modulation 44 étant configurée pour générer des signaux en modulation de largeur d'impulsion, également appelés signaux MLI ou signaux PWM (de l'anglais *Pulse Width Modulation*), notés $\rho_a$, $\rho_b$, $\rho_c$, dans l'exemple de la figure 2 où la machine électrique 26 est un moteur triphasé, ladite unité de commande 42 étant configurée pour commander ladite unité de modulation 44 via un taux de modulation mod et une fréquence de glissement $f_s$, ou encore via une fréquence de commutation et un rapport cyclique, ladite unité de mesure 46 étant configurée pour mesurer des courants d'au moins une phase de la machine électrique 26, notés par exemple $i_{sa}$, $i_{sb}$ sur la figure 2, en des bornes de sortie 38 du convertisseur d'énergie électrique 30, puis transmettre les mesures de courant $i_{s\alpha}$ et $i_{s\beta}$ à l'unité de commande 42 afin de permettre une régulation par rétroaction de la machine électrique 26.

La chaîne de traction 12 comprend un dispositif d'estimation 50 relié au dispositif de pilotage 40, et configuré pour estimer une valeur de la résistance rotorique $Rr$ de la machine électrique 26.

Le dispositif d'estimation 50 comprend un module d'injection 52 configuré pour déterminer une consigne de flux $\varphi^{\#}$ à injecter en entrée du dispositif de pilotage 40, comme indiqué par la flèche F1. Le dispositif d'estimation 50 comprend un module d'acquisition 54 configuré pour acquérir une mesure d'un courant $Id_n$ représentatif d'un courant d'une phase de la machine électrique à un instant temporel $T_n$ donné, où n est un indice entier positif, dont la valeur est incrémentée d'une unité à chaque nouvelle acquisition. Le dispositif d'estimation 50 comprend un module de calcul 56 configuré pour calculer la valeur d'une résistance rotorique $Rr_{n+1}$ de la machine électrique à un instant temporel suivant $T_{n+1}$, postérieur à l'instant temporel $T_n$ donné.

L'homme du métier comprendra que le dispositif d'estimation 50 est configuré pour estimer, par exemple de manière itérative, la valeur de la résistance rotorique $Rr$ de la machine électrique 26, et que l'indice n est alors associé à ces itérations successives. Par convention, l'indice 0 correspond à une itération initiale mise en œuvre avec des valeurs initiales prédéfinies de la résistance rotorique $Rr_0$ et du courant $Id_0$ ; l'indice n est associé à une itération courante, et l'indice n+1 est associé à une itération suivante mise en œuvre à partir des valeurs obtenues à l'itération qui la précède, c'est-à-dire à partir de l'itération courante d'indice n.

Dans l'exemple de la figure 2, le dispositif d'estimation 50 comprend une unité de traitement d'informations formée par exemple d'une mémoire et d'un processeur associé à la mémoire, non représentés.

Dans l'exemple de la figure 2, le module d'injection 52, le module d'acquisition 54 et le module de calcul 56 sont réalisés chacun sous forme d'un logiciel, ou d'une brique logicielle, exécutable par le processeur. La mémoire du dispositif d'estimation 50 est alors apte à stocker un logiciel d'injection configuré pour déterminer une consigne de flux $\varphi^{\#}$ à injecter en entrée du dispositif de pilotage 40, un logiciel d'acquisition configuré pour acquérir une mesure d'un courant $Id_n$ représentatif d'un courant d'une phase de la machine électrique à un instant temporel $T_n$ donné, et un logiciel de calcul configuré pour calculer une valeur d'une résistance rotorique $Rr_{n+1}$ de la machine électrique à un instant temporel suivant $T_{n+1}$, postérieur à l'instant temporel $T_n$ donné. Le processeur est alors apte à exécuter chacun des logiciels parmi le logiciel d'injection, le logiciel d'acquisition, et le logiciel de calcul.

En variante non représentée, le module d'injection 52, le module d'acquisition 54 et le module de calcul 56 sont réalisés chacun sous forme d'un composant logique programmable, tel qu'un FPGA (de l'anglais *Field Programmable Gate Array),* un DSP (de l'anglais *Digital Signal Processor),* ou encore sous forme d'un circuit intégré dédié, tel qu'un ASIC (de l'anglais *Application Specific Integrated Circuit).*

Lorsque le dispositif d'estimation 50 est réalisé sous forme d'un ou plusieurs logiciels, c'est-à-dire sous forme d'un programme d'ordinateur, il est en outre apte à être enregistré sur un support, non représenté, lisible par ordinateur. Le support lisible par ordinateur est, par exemple, un médium apte à mémoriser des instructions électroniques et à être couplé à un bus d'un système informatique. A titre d'exemple, le support lisible est une disquette ou disque souple (de l'anglais *Floppy Disk),* un disque optique, un CD-ROM, un disque magnéto-optique, une mémoire ROM, une mémoire RAM, tout type de mémoire non volatile (par exemple EPROM, EEPROM, FLASH, NVRAM), une carte magnétique ou une carte optique. Sur le support lisible est alors mémorisé un programme d'ordinateur comprenant des instructions logicielles.

Le dispositif d'estimation 50 est configuré pour estimer la résistance rotorique Rr de la machine électrique 26 en l'absence d'un capteur de mesure d'une vitesse rotorique de la machine électrique 26.

Le dispositif d'estimation 50 est configuré pour estimer la résistance rotorique Rr de la machine électrique 26 en l'absence d'un capteur de mesure d'un flux de la machine électrique 26.

Le module d'injection 52 est, d'une part, relié à l'entrée du dispositif de pilotage 40, et d'autre part, relié au module d'acquisition 54. Le module d'injection 52 est configuré pour déterminer la consigne de flux $\varphi^{\#}$ à injecter en entrée du dispositif de pilotage 40. L'unité de commande 42 est alors configuré pour émette, en fonction de la consigne de flux $\varphi^{\#}$ ainsi reçue, une commande vers l'unité de modulation 44, permettant à l'unité de modulation 44 de générer des signaux MLI, à savoir $\rho_a$, $\rho_b$, $\rho_c$, qui sont ensuite transmis au convertisseur d'énergie électrique 30 pour engendrer une variation du flux de la machine 26.

Le module d'injection 52 est également configuré pour transmettre la consigne de flux $\varphi^{\#}$ déterminée au module de calcul 56, le module de calcul 56 étant alors configuré pour déterminer, à partir de la consigne de flux $\varphi^{\#}$ ainsi reçue, une variation de la consigne de flux $\dot{\varphi}^{\#}$ correspondant à un intervalle de temps considéré.

Le module d'injection 52 est de préférence configuré pour déterminer une consigne de flux $\varphi^{\#}$ en forme d'un signal triangulaire.

Le module d'injection 52 est de préférence configuré pour déterminer une consigne de flux $\varphi^{\#}$ ayant une composante variable avec une fréquence comprise entre 1 Hz et 10 Hz.

Le flux de la machine électrique 26 a une composante continue, la consigne de flux $\varphi^{\#}$ variable a une composante variable, et l'amplitude de ladite composante variable est supérieure ou égale à 15% de celle de ladite composante continue.

Dans l'exemple de la figure 2, le module d'acquisition 54 est relié à la sortie de l'unité de mesure 46, et est configuré pour acquérir une image Id, correspondant à un courant selon un axe direct, et Iq, correspondant à un courant selon un axe en quadrature, des mesures de courant $i_{s\alpha}$ et $i_{s\beta}$, comme représenté par la flèche F2.

En variante, non représentée, le module d'acquisition 54 est relié à la sortie 38 du convertisseur d'énergie électrique 30 et est configuré pour acquérir directement des mesures de courant d'au moins une phase de la machine électrique 26.

Le module de calcul 56 est relié au module d'injection 52 pour recevoir la consigne de flux $\varphi^{\#}$ déterminée, destinée à être injectée en entrée du dispositif de pilotage 40, et également relié au module d'acquisition 54 pour recevoir la mesure d'un courant $Id_n$ représentatif d'un courant d'une phase de la machine électrique 26 à l'instant temporel $T_n$ donné.

Le module de calcul 56 est de préférence configuré pour calculer la valeur de la résistance rotorique $Rr_{n+1}$ en fonction en outre de l'inductance rotorique $L_r$ et de l'inductance magnétisante $L_m$.

Le module de calcul 56 est, par exemple, configuré pour calculer la valeur de la résistance rotorique $Rr_{n+1}$ selon l'équation suivante :

[Math 3]

$$Rr_{n+1} = \dot{\varphi}^{\#} \cdot \frac{1}{Id_n} \cdot G$$

où $\dot{\varphi}^{\#}$ est la variation de la consigne de flux ;

$Id_n$ est le courant représentatif du courant de phase selon l'axe direct, mesuré à l'instant temporel donné $T_n$;

G représentant un facteur dépendant de la valeur précédente de résistance rotorique $Rr_n$ pour ledit instant temporel donné $T_n$, de l'inductance rotorique $L_r$ et de l'inductance magnétisante $L_m$.

Le facteur G dans l'équation (3) ci-dessus vérifie, par exemple, l'équation :

[Math 4]

$$G = \frac{L_r}{L_m} \cdot \left( \frac{1 + \frac{L_r}{Rr_n}p}{\frac{L_r}{Rr_n}p} \right)$$

avec $\dfrac{L_r}{Rr_n}\,p$ correspondant au Laplacien de $\dfrac{L_r}{Rr_n}$.

Le module de calcul 56 est alors, par exemple, configuré pour calculer la valeur de la résistance rotorique $Rr_{n+1}$ selon l'équation suivante :

[Math 5]

$$Rr_{n+1} = \dot{\varphi}^{\#} \cdot \frac{L_r}{L_m} \cdot \left( \frac{1 + \dfrac{L_r}{Rr_n}p}{\dfrac{L_r}{Rr_n}p} \right) \cdot \frac{1}{Id_n}$$

où $\dot{\varphi}^{\#}$ est la variation de la consigne de flux ;

$L_r$ est l'inductance rotorique de la machine électrique 26 ;

$L_m$ est l'inductance magnétisante de la machine électrique 26 ;

$Rr_n$ est une valeur précédente de résistance rotorique Rr pour ledit instant temporel donné $T_n$;

$\dfrac{L_r}{Rr_n}\,p$ correspondant au Laplacien de $\dfrac{L_r}{Rr_n}$,

$Id_n$ est le courant représentatif du courant de phase selon l'axe direct, mesuré à l'instant temporel donné $T_n$.

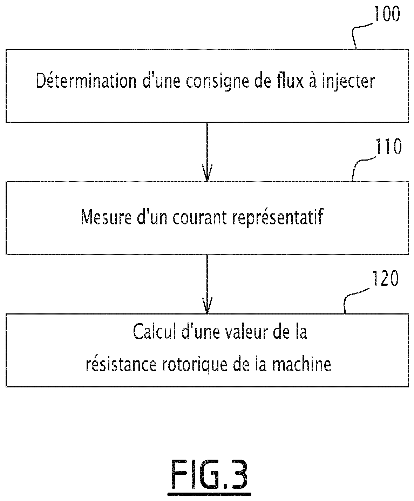

Le fonctionnement du dispositif d'estimation 50 selon l'invention va être à présent décrit à l'aide de la figure 3 représentant un organigramme du procédé d'estimation selon l'invention.

Lors d'une étape initiale 100, le dispositif d'estimation 50 détermine, via son module d'injection 52, une consigne de flux $\varphi^{\#}$ à injecter en entrée du dispositif de pilotage 40.

Suite à l'injection de la consigne de flux $\varphi^{\#}$ déterminée lors de l'étape initiale 100, le dispositif d'estimation 50 acquiert, lors d'une étape suivante 110 et via son module d'acquisition 54, une mesure du courant $Id_n$ représentatif du courant de phase selon l'axe direct de la machine électrique 26 à l'instant temporel $T_n$ donné, et transmet ensuite cette mesure de courant $Id_n$ au module de calcul 56.

Lors de cette étape 110, le module de calcul 56 reçoit la consigne de flux $\varphi^{\#}$ déterminée lors de l'étape initiale 100, et détermine à partir de celle-ci une variation de la consigne de flux $\dot{\varphi}^{\#}$ correspondant à l'intervalle temporel entre l'instant temporel $T_n$ donné et l'instant temporel suivant $T_{n+1}$, postérieur à l'instant temporel $T_n$ donné.

Ensuite, lors d'une étape 120, le dispositif d'estimation 50 calcule, via son module de calcul 56, la valeur $Rr_{n+1}$ de la résistance rotorique Rr de la machine électrique 26 à l'instant temporel suivant $T_{n+1}$, postérieur à l'instant temporel $T_n$ donné, en fonction de la variation de la consigne de flux $\dot{\varphi}^{\#}$, d'une valeur précédente $Rr_n$ de la résistance rotorique Rr pour ledit instant temporel $T_n$ donné, et du courant mesuré $Id_n$ représentatif du courant de phase audit instant temporel $T_n$ donné, les valeurs initiales $Rr_0$, $Id_0$ de la résistance rotorique Rr et du courant Id étant prédéfinies.

Lors de l'étape 120, le module de calcul 56 calcule de préférence la valeur $Rr_{n+1}$ de la résistance rotorique Rr de la machine électrique 26 à l'instant temporel suivant $T_{n+1}$, en fonction en outre de l'inductance rotorique $L_r$ et de l'inductance magnétisante $L_m$.

Notons ici G un facteur dépendant de la valeur précédente de résistance rotorique $Rr_n$ pour ledit instant temporel $T_n$ donné, de l'inductance rotorique $L_r$ et de l'inductance magnétisante $L_m$, le calcul de la valeur de la résistance rotorique $Rr_{n+1}$ est alors réalisée en utilisant l'équation (3) précédente.

Le paramètre G dans l'équation (3) ci-dessus est, par exemple, selon l'équation (4) précédente, et le calcul de la valeur $Rr_{n+1}$ de la résistance rotorique Rr est alors, par exemple, réalisé en utilisant l'équation (5) précédente.

Ainsi, le dispositif électronique d'estimation 50 selon la présente invention permet d'estimer, au cours du fonctionnement de la machine électrique 26, une valeur de la résistance rotorique Rr indépendamment d'une mesure de la vitesse de rotation du rotor de la machine électrique 26.

Le dispositif d'estimation 50 permet alors d'estimer la résistance rotorique Rr de la machine électrique 26 en l'absence d'un capteur de mesure d'une vitesse rotorique de la machine électrique 26. Le dispositif d'estimation 50 permet également d'estimer ladite résistance rotorique Rr en l'absence d'un capteur de mesure d'un flux de la machine électrique 26.

Le dispositif d'estimation 50 selon l'invention permet ainsi une régulation simplifiée de la machine électrique 26 avec une estimation plus robuste de la résistance rotorique Rr de ladite machine 26, cette estimation étant moins sensible à une erreur de mesure, notamment sur l'inductance magnétisante $L_m$. En effet, avec dispositif d'estimation 50 selon l'invention, une erreur $\Delta L_m$ sur l'inductance magnétisante $L_m$ engendrera, d'après l'équation (4) précédente une erreur d'estimation pour le facteur G de l'ordre de :

[Math 6]

$$\frac{L_m}{L_m + \Delta L_m} \approx 1 - \frac{\Delta L_m}{L_m}$$

Ainsi, une erreur sur l'inductance magnétisante $L_m$ de la machine 26 engendre une erreur du même ordre sur la résistance rotorique Rr estimée.

Au contraire, ainsi que cela a été montré en introduction, le dispositif d'estimation de l'état de la technique est particulièrement sensible à une erreur sur la valeur de l'inductance magnétisante $L_m$.

On conçoit ainsi que le dispositif électronique d'estimation 50 et le procédé d'estimation selon l'invention permettent d'estimer la résistance rotorique Rr de la machine électrique 26, en n'utilisant pas de mesure de la vitesse de rotation de ladite machine 26, tout en permettant d'obtenir une valeur plus fiable de la résistance rotorique Rr.

**Revendications**

1. Dispositif électronique (50) d'estimation d'une résistance rotorique (Rr) d'une machine électrique (26), ladite machine électrique (26) étant destinée à être embarquée dans un véhicule (10) pour tracter ledit véhicule (10), tel qu'un véhicule électrique de transport, par exemple un véhicule ferroviaire, et apte à être connectée à un convertisseur d'énergie électrique (30), ledit convertisseur d'énergie électrique (30) étant configuré pour alimenter électriquement la machine (26) à partir d'une source électrique et étant apte à être piloté par un dispositif de pilotage (40),

   le dispositif d'estimation (50) étant apte à être relié au dispositif de pilotage (40) du convertisseur d'énergie électrique et comprenant :

   - un module d'injection (52) configuré pour déterminer une consigne de flux ($\varphi^{\#}$) à injecter en entrée du dispositif de pilotage (40) ;
   - un module d'acquisition (54) configuré pour acquérir une mesure d'un courant ($Id_n$) représentatif d'un courant d'au moins une phase de la machine électrique (26) à un instant temporel donné ($T_n$) ; et
   - un module de calcul (56) configuré pour calculer une valeur de la résistance rotorique ($Rr_{n+1}$) de la machine électrique (26) à un instant temporel suivant ($T_{n+1}$), postérieur à l'instant temporel donné ($T_n$), en fonction d'une variation de la consigne de flux ($\dot{\varphi}^{\#}$), d'une valeur précédente de la résistance rotorique ($Rr_n$) pour ledit instant temporel donné ($T_n$), et du courant mesuré ($Id_n$) représentatif du courant de phase audit instant temporel donné ($T_n$) ; des valeurs initiales de la résistance rotorique ($Rr_0$) et du courant ($Id_0$) étant prédéfinies.

2. Dispositif (50) selon la revendication 1, dans lequel ladite machine électrique (26) a une inductance rotorique ($L_r$) et une inductance magnétisante ($L_m$), et

   le module de calcul (56) est configuré pour calculer la valeur de la résistance rotorique ($Rr_{n+1}$) en fonction en outre de l'inductance rotorique ($L_r$) et de l'inductance magnétisante ($L_m$).

3. Dispositif (50) selon la revendication 2, dans lequel le module de calcul (56) est configuré pour calculer la valeur de la résistance rotorique ($Rr_{n+1}$) selon l'équation suivante :

$$Rr_{n+1} = \dot{\varphi}^{\#} \cdot \frac{1}{Id_n} \cdot G$$

   où $\dot{\varphi}^{\#}$ est la variation de la consigne de flux ;
   $Id_n$ est le courant représentatif du courant de phase selon un axe direct, mesuré à l'instant temporel donné ($T_n$);
   G représentant un facteur dépendant de la valeur précédente de résistance rotorique ($Rr_n$) pour ledit instant temporel donné ($T_n$), de l'inductance rotorique ($L_r$) et de l'inductance magnétisante ($L_m$).

4. Dispositif (50) selon la revendication 3, dans lequel le module de calcul (56) est configuré pour calculer la valeur de la résistance rotorique ($Rr_{n+1}$) selon l'équation suivante :

$$Rr_{n+1} = \dot{\varphi^{\#}} \cdot \frac{L_r}{L_m} \cdot \left( \frac{1 + \frac{L_r}{Rr_n}p}{\frac{L_r}{Rr_n}p} \right) \cdot \frac{1}{Id_n}$$

où $\dot{\varphi^{\#}}$ est la variation de la consigne de flux ;

$L_r$ est l'inductance rotorique de la machine électrique (26);

$L_m$ est l'inductance magnétisante de la machine électrique (26);

$Rr_n$ est une valeur précédente de résistance rotorique pour ledit instant temporel donné ($T_n$) ;

$\frac{L_r}{Rr_n} p$ correspondant au Laplacien de $\frac{L_r}{Rr_n}$,

$Id_n$ est le courant représentatif du courant de phase selon l'axe direct, mesuré à l'instant temporel donné ($T_n$).

5. Dispositif (50) selon l'une des revendications précédentes, dans lequel le module d'injection (52) est configuré pour déterminer une consigne de flux ($\varphi^{\#}$) en forme d'un signal triangulaire.

6. Dispositif (50) selon l'une des revendications précédentes, dans lequel le flux de la machine électrique (26) a une composante continue, la consigne de flux ($\varphi^{\#}$) a une composante variable, et l'amplitude de ladite composante variable est supérieure ou égale à 15% de celle de ladite composante continue.

7. Dispositif (50) selon la revendication 6, dans lequel le module d'injection (52) est configuré pour déterminer une consigne de flux ($\varphi^{\#}$) ayant une composante variable avec une fréquence comprise entre 1 Hz et 10 Hz.

8. Procédé d'estimation d'une résistance rotorique (Rr) d'une machine électrique (26), ladite machine électrique (26) étant destinée à être embarquée dans un véhicule (10) pour tracter ledit véhicule (10), tel qu'un véhicule électrique de transport, par exemple un véhicule ferroviaire, et apte à être connectée à un convertisseur d'énergie électrique (30), ledit convertisseur d'énergie électrique (30) étant configuré pour alimenter électriquement la machine (26) à partir d'une source électrique et étant apte à être piloté par un dispositif de pilotage (40),
le procédé d'estimation étant mis en œuvre par un dispositif électronique d'estimation (50), et comprenant :

- détermination d'une consigne de flux ($\varphi^{\#}$) à injecter en entrée du dispositif de pilotage (40) ;
- mesure d'un courant ($Id_n$) représentatif d'un courant d'une phase de la machine électrique (26) à un instant temporel donné ($T_n$) ; et
- calcul d'une valeur de la résistance rotorique ($Rr_{n+1}$) de la machine électrique (26) à un instant temporel suivant ($T_{n+1}$), postérieur à l'instant temporel donné ($T_n$) en fonction d'une variation de la consigne de flux ($\dot{\varphi^{\#}}$), d'une valeur précédente de la résistance rotorique ($Rr_n$) pour ledit instant temporel donné ($T_n$), et du courant mesuré ($Id_n$) représentatif du courant de phase audit instant temporel donné ; des valeurs initiales de la résistance rotorique ($Rr_0$) et du courant ($Id_0$) étant prédéfinies.

9. Chaine de traction (12) pour un véhicule (10), tel qu'un véhicule électrique de transport, par exemple un véhicule ferroviaire, la chaine de traction (12) comprenant :

- une machine électrique (26) adaptée pour tracter ledit véhicule (26),
- un convertisseur d'énergie électrique (30) connecté à la machine électrique (26) et configuré pour alimenter électriquement la machine (26) à partir d'une source électrique,
- un dispositif de pilotage (40) configuré pour piloter le convertisseur d'énergie électrique (30),
- un dispositif électronique d'estimation (50) configuré pour estimer une résistance rotorique d'une machine électrique,

**caractérisée en ce que** le dispositif électronique d'estimation (50) est selon l'une quelconque des revendications 1 à 7.

10. Véhicule (10), tel qu'un véhicule électrique de transport, par exemple un véhicule ferroviaire, comprenant une chaine de traction (12) selon la revendication 9.

FIG.1

EP 3 739 350 A1

## FIG.2

11

| Détermination d'une consigne de flux à injecter | 100 |

| Mesure d'un courant représentatif | 110 |

| Calcul d'une valeur de la résistance rotorique de la machine | 120 |

## FIG.3

EP 3 739 350 A1

**Europäisches Patentamt**
**European Patent Office**
**Office européen des brevets**

# RAPPORT DE RECHERCHE EUROPEENNE

Numéro de la demande

EP 20 17 4631

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 3 401 694 A1 (SCHNEIDER TOSHIBA INVERTER EUROPE SAS [FR]) 14 novembre 2018 (2018-11-14) | 1-3,7-10 | INV. G01R31/34 H02P21/14 H02P21/16 |
| A | * abrégé; figures 1-5 * * alinéas [0004], [0010] - [0020], [0024], [0026], [0032] - [0046] * * page 5, ligne 15 - page 9, ligne 12 * * page 12, ligne 4 - page 15, ligne 8 * ----- | 4-6 | |
| A | DE 34 30 386 A1 (SIEMENS AG [DE]) 20 février 1986 (1986-02-20) * page 5, ligne 15 - page 9, ligne 12 * * page 12, ligne 4 - page 15, ligne 8 * ----- | 1-10 | |

| DOMAINES TECHNIQUES RECHERCHES (IPC) |
|---|
| G01R H02P |

Le présent rapport a été établi pour toutes les revendications

| Lieu de la recherche | Date d'achèvement de la recherche | Examinateur |
|---|---|---|
| Munich | 17 août 2020 | Kleiber, Michael |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

13

**ANNEXE AU RAPPORT DE RECHERCHE EUROPEENNE
RELATIF A LA DEMANDE DE BREVET EUROPEEN NO.**

EP 20 17 4631

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-08-2020

| Document brevet cité au rapport de recherche | | | Date de publication | Membre(s) de la famille de brevet(s) | | | Date de publication |
|---|---|---|---|---|---|---|---|
| EP 3401694 | A1 | | 14-11-2018 | CN | 108880367 | A | 23-11-2018 |
| | | | | EP | 3401694 | A1 | 14-11-2018 |
| | | | | ES | 2743609 | T3 | 20-02-2020 |
| | | | | FR | 3066276 | A1 | 16-11-2018 |
| | | | | JP | 2018191506 | A | 29-11-2018 |
| | | | | US | 2018328969 | A1 | 15-11-2018 |
| DE 3430386 | A1 | | 20-02-1986 | AUCUN | | | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **HISAO KUBOTA ; KOUKI MATSUSE.** Speed Sensorless Field-Oriented Control of Induction Motor with Rotor Resistance Adaption. *IEEE Transactions on Industry Applications,* Septembre 1994, vol. 30 (5